# EUROPEAN PATENT SPECIFICATION

(11) **EP 0 921 638 B1**
(45) Date of publication and mention of the grant of the patent: **21.05.2003**
(21) Application number: 98309960.7
(22) Date of filing: 04.12.1998
(51) Int. Cl.: H03K 19/00, H03K 19/0175, H03K 19/0944

(54) **Bus driver circuit**
Bus-Treiberschaltung
Circuit d'attaque de bus

(30) Priority: 05.12.1997 US 67702 P; 30.12.1997 US 68976 P
(43) Date of publication of application: 09.06.1999
(73) Proprietor: TEXAS INSTRUMENTS DEUTSCHLAND GMBH, 85350 Freising (DE)
(72) Inventor: Rombach, Gerd, 85354 Freising (DE)
(74) Representative: Holt, Michael

(56) References cited:
- EP-A- 0 374 782
- EP-A- 0 418 466
- EP-A- 0 621 693
- EP-A- 0 780 752
- JP-A- 4 040 115
- US-A- 4 980 578
- US-A- 5 077 490

## Description

### Field Of The Invention

The present invention relates to integrated bus drivers.

### Background: Bus Interface Device

Integrated bus interface devices must be capable of sinking or sourcing high output current when the output switches. A current in the range from 50 - 100mA is typical. The high current is necessary to achieve fast propagation delay times (typically driving a 75-ohm transmission line). After the output has reached the stable steady state, only a small part of the switching current, or even no current is needed.

In BiCMOS chips, bipolar NPN transistors were traditionally used to deliver the high sink current that was needed for bus driver devices. However, while bipolar output drivers provide fast high-current output switching, they have the disadvantage of a large static power consumption.

In present day computer systems, the buses spend 80% or more of their time in the stable, inactive (low or high) state. Modern bus interface ICs take this into account. The circuits are designed for self-control of internal power consumption based upon what is needed to drive the output load. Power-On-Demand ("POD") circuits reduce power drain. The first circuits employing this feature appeared in 1992. However, a major limitation of these earlier designs is that the output clamping voltage is dependent on the output current. If current through the output transistor increases, the base-emitter voltage Vbe also increases, due in part to the emitter resistance of the output transistor. See Applicant's prior German application (#De 195 47 754 C1, Control Circuit for a BiCMOS Bus Driver).

Another document, JP-A- 4 040 115 discloses a bus drive circuit with a bipolar output transistor and with a field-effect transistor for detecting variations in the output voltage. A reference voltage generator is formed by a series-connection of a schottky diode and a pm diode. The base current of the output transistor is varied to oppose variations of the output voltage.

### Summary Of The Present Invention

The present application discloses an innovative technique for controlling power consumption in a BiCMOS bus driver circuit. A bipolar output driver is used with a MOS base drive circuit which includes a feedback relationship; as output current rises, the base current also rises. The base drive circuit reacts quickly to changes in the load impedance. The bipolar output driver still provides fast switching, and high peak current when needed, but the base drive circuit limits the static base current to a small value except when more is needed. The preferred feedback circuit configuration is nearly temperature and process compensated, and therefore easy to implement in different processes.

Thus the disclosed innovations reduce wasted power consumption. Moreover, the disclosed innovations can be used advantageously for all bus driver devices that are processed in BiCMOS technology. Another advantage is that the base current of the lower output transistor is controlled such that the output voltage stays constant regardless of how large or small the output sink current is. Another advantage is that the power consumption of the circuit is strongly related to the output sink current. Another advantage is that the technique works in the various power supply regimes of 2.5V, 3.3V, or 5.0V.

### Brief Description of the Drawings

The disclosed inventions will be described with reference to the accompanying drawings, which show important sample embodiments of the invention and which are incorporated in the specification hereof by reference, wherein:
Figure 1 shows a preferred embodiment of the circuit.
Figure 2 shows a prior art circuit for the lower output transistor of a bus driver.
Figure 3 shows a prior art driver circuit where base current is switch controlled to a fixed resistor value.
Figure 4 shows a typical integrated circuit chip with the driver circuit.

### Detailed Description of the Preferred Embodiments

The numerous innovative teachings of the present application will be described with particular reference to the presently preferred embodiment. However, it should be understood that this class of embodiments provides only a few examples of the many advantageous uses of the innovative teachings herein. Moreover, some statements may apply to some inventive features but not to others.

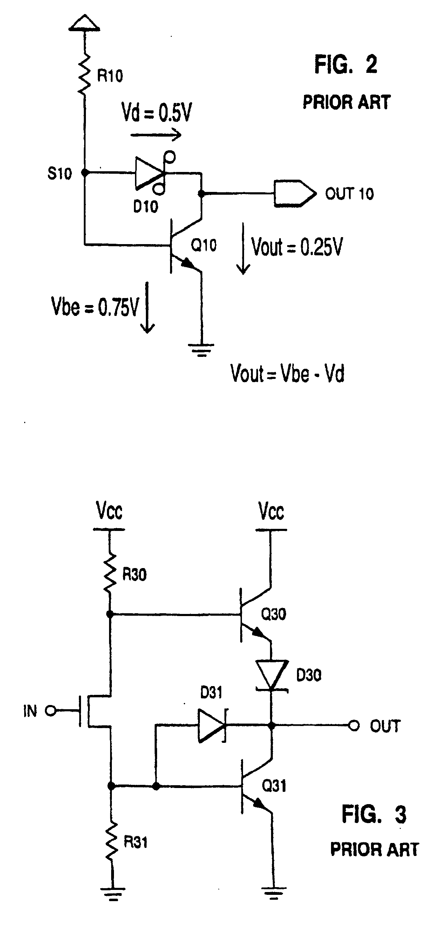

Figure 2 shows the principle circuit for the lower output transistor of a bus driver. The clamping diode D10 is used to prevent the output cransistor Q10 from saturating. The base current of Q10 is defined by the resistor value of R10. The resistor has to be designed small enough to guarantee a maximum value drive sink current at output OUT10. If the actual drive sink current is less than the maximum value, a part of the base current will flow through the clamping diode D10. Thus the current will not be available at the output, but be conducted through the diode and wasted.

Figure 3 shows a prior art driver circuit where base current is switch controlled to a fixed resistor value. When the input IN is low, transistor Q31 is biased "Off" since no base current exists. Transistor Q30 conducts based upon the base current developed from resistor R30. When the input IN is high, transistor Q31 is biased to conduct based upon the R30/R31 divider. In this case, most of the base current of the lower output transistor Q31 will sink through the clamping diode to ground. (The lower output transistor Q31 of a bus driver is usually clamped by a Schottky diode D31 to prevent the transistor from going into saturation.) This part of the current will be wasted at that time.

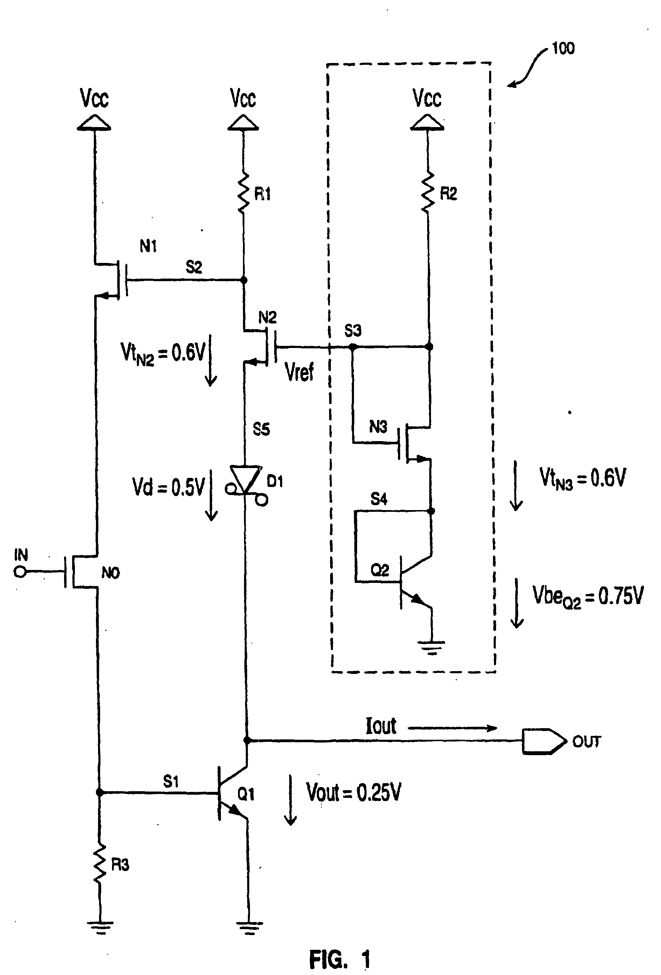

Figure 1 shows a preferred embodiment of the circuit. NPN bipolar transistor Q1 is the output driver. The base current of Q1 is not set by a fixed resistor value, as is done in conventional circuits. Instead, the base current is controlled by the On-resistance of the NMOS transistors N1 and N0, and the resistance R3.

An output signal (from the internal circuits of the chip) is applied at terminal IN to the gate of transistor N0. When the signal at IN is high, the transistor Q1 is turned "On" to pull the OUT terminal low. This state is the one where the static power dissipation issues discussed above are most critical, and thus most of the following discussion will focus on this output state.

Transistor N1 is turned "On" or "Off" by transistor N2. The state of transistor N2 depends upon the output voltage Vout, and is set by the network of transistors N2, N3, and Q2, and Schottky diode D1. When the output current Iout rises, the voltage across the collector-emitter of Q1 (Vout) will also rise, until the base current of transistor Q1 is regulated to a higher value.

Resistor R2, NMOS transistor N3, and bipolar transistor Q2, comprise a reference voltage circuit 100 which generates a reference voltage Vref at node s3. This reference voltage Vref is set by a NMOS transistor N3 threshold voltage Vt_{N3}, and a base-emitter voltage Vbe_{Q2} of a bipolar N?N transistor Q2. Typical approximate voltage values for each are Vt_{N3} = 0.6V and Vbe_{Q3} = 0.75V. The gate of NMOS transistor N2 is connected to the reference voltage circuit 100 at node s3. Transistor N2 becomes conducting if the voltage across transistor N2, diode D1, and the output voltage Vout, is less than the reference voltage Vref at node s3. Correspondingly, transistor N2 becomes less conducting as the output voltage rises, and turns "Off" when its source voltage, plus its threshold voltage, becomes greater than the reference voltage.

When the voltage at the output OUT rises, transistor N2 turns "Off", voltage at node s2 rises, and transistor N1 conducts. When transistor N1 conducts, the base drive of transistor Q1 increases. (Both transistors N1 and N2 are biased weakly, such that transistor N1 is weakly on with low current demands at the output, and heavily on for high current demands at the output.) Transistor Q1 will turn "On" more, and the output voltage Vout will fall back to the initial value.

Since the threshold voltages (Vt, Vbe, and Vd) are fixed, and set by process parameters, the switching of transistor N2 depends only upon the output voltage Vout. The forward voltage Vd of the Schottky diode D1 is approximately 0.5V. The value of the output voltage Vout is approximately 0.25V, or essentially the difference between the voltage drop across the base-emitter of transistor Q2, and the forward voltage of the Schottky diode D1. That is, Vout = (Vbe_{Q2} + Vt_{N3}) - (Vd + Vt_{N2})
= (0.75 + 0.6) - (0.5 + 0.6) = 0.25V.

Typical devices sizes for a 0.6 micron process, and resistor values of 50K ohms for both R1 and R2, may be for example 50x60 square micrometers in a 500 ohm/square sheet resistance, for devices R1, and R2. Approximate transistor sizes are the following;
N1=40/0.6, N2=8/0.6, N3=8/0.6, Q1 emitter area = 250x0.6 for 60 milliamps, Q2 emitter area = 3x0.6, D1 Schottky area = 30.

Key features of the innovative circuit are that the output voltage Vout is clamped, preventing the transistor Q1 from going into saturation. Arocher feature is that the base current of transistor Q1 is controlled so that the output voltage stays constant regardless of transistor Q1 collector current. Another feature is that the output voltage is nearly temperature compensated, since the temperature shift of the components in the control circuit cancel each other. The gate voltages of NMOS transistors N2 and N3 have the same temperature drift.
Furthermore, the diode D1 forward voltage (Vd) temperature drift is compensated for by the base-emitter voltage drift of transistor Q2. Another feature is that the output voltage is partly process compensated - the influence of CMOS transistors N2 and N3 threshold voltages are cancelled out. Finally, the output clamping voltage is independent of the output current.

Note also that, in the presently preferred embodiment, the delay-limiting path of the feedback circuit includes only MOS transistors N1 and N2. Thus this feedback circuit can react quickly to load variations.

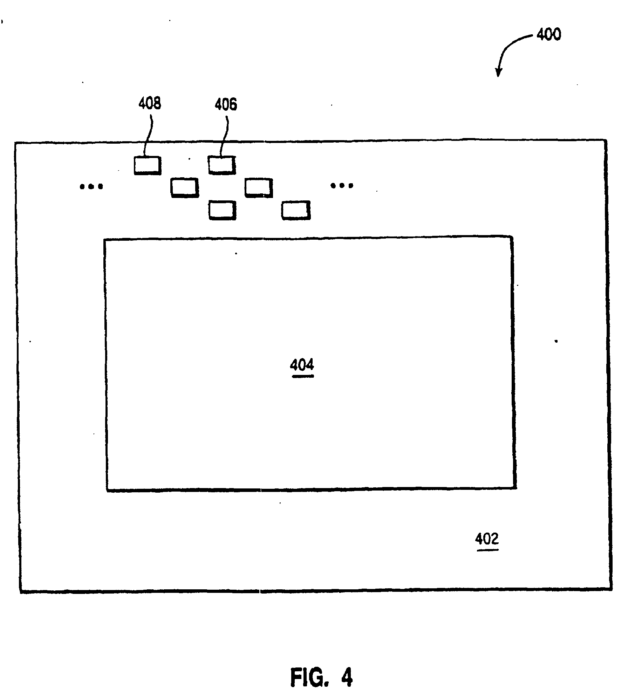

Figure 4 shows a typical integrated circuit chip with the driver circuit. IC 400 comprises a core circuitry 404 surrounded by I/O circuitry on the periphery 402 of the chip. The I/O circuitry comprises static discharge protection circuitry 406 and driver circuitry 408. Driver circuits like those of Figure 1 would preferably be used for some (but not necessarily all) of the output drivers in driver circuitry 408.

The illustrated embodiment is a simple low-side driver configuration. However, of course a variety of port interface circuits can be combined with the circuitry shown. For example, an active pull-up circuit can also be used in combination with the driver circuit portion shown.

A complementary circuit configuration can also be used to limit static base current to a PNP high-side driver.

For another example, within the constraints well-known to those of ordinary skill, a variety of well-known reference circuit configurations can be substituted for those shown.

For another example, within the constraints well-known to those of ordinary skill, components may be added to speed up the feedback circuit.

For another example, within the constraints well-known to those of ordinary skill, components may be added to switch off the whole circuit from its supply voltage, during a power-down event.

## Claims

1. An integrated bus interface driver circuit, comprising
a bipolar transistor (Q1) connected for controllably driving an output terminal (OUT) to a defined level in response to a bus drive signal (IN); and including
a feedback circuit, comprising one or more field-effect transistors connected for detecting variations in the voltage (Vout) of said output terminal (OUT), and accordingly, when a variation in said output voltage (Vout) is detected, vary the base current of said bipolar transistor (Q1) thereby to vary the current applied by said bipolar transistor (Q1) at said output terminal (OUT) to oppose said variation in the voltage (Vout) of said output terminal (OUT) and maintain said defined level,
wherein the control terminal of one (N2) of said field-effect transistors, which is connected to follow the voltage (Vout) of said output terminal (OUT), is connected to a. reference voltage (Vref), said reference voltage being set with respect to said defined output level; and
wherein said feedback circuit comprises a first field-effect transistor (N1) for providing base current to said bipolar transistor (Q1), and a second field-effect transistor (N2) which is the one connected to follow the voltage (Vout) of said output terminal, the second field-effect transistor (N2) controlling a gate voltage of said first field-effect transistor (N1), and the first field-effect transistor (N1) being series-connected with an input field effect-transistor (N0).

2. The integrated circuit of Claim 1, wherein the feedback circuit further comprises a circuit for generating the reference voltage (Vref).

3. The integrated circuit of Claim 2, wherein the circuit for generating the reference voltage (Vref) comprises a series connection of a gate-drain-connected field effect transistor (N3) and a base-collector-connected bipolar transistor (Q2).

4. The integrated circuit of any of Claims 1 to 3, wherein said feedback circuit is temperature compensated.
the bus drive signal being applied to the control terminal of said input transistor.

5. The integrated circuit of Claim, further comprising a Schottky diode (D1) disposed between a source of said second field-effect transistor (N2) and said output terminal (OUT).

6. A method for controlling a bus interface circuit, comprising the steps of:
controllably driving an output terminal (OUT) to a defined level with a bipolar transistor (Q1) in response to a bus drive signal (IN),
connecting a feedback circuit comprising one or more field-effect transistors to vary the base current of said bipolar transistor (Q1) when said output voltage (Vout) varies, to thereby vary the current applied by said bipolar transistor (Q1) at said output terminal (OUT) to oppose any variation in the voltage of said output terminal (OUT) and maintain said defined level, connecting one (N2) of said field-effect transistors to follow the voltage (Vout) of said output terminal (OUT) and connecting the control terminal of said field-effect transistor (N2) to a reference voltage (Vref) and setting said reference voltage with respect to said defined output level;
providing said base current by a further field - effect transistor (N1) connected in series with an input field-effect transistor (N0),
applying the bus drive signal (IN) to the control terminal of the input field-effect transistor (N0),
and the further field-effect transistor (N1) having its control terminal connected to the field - effect transistor (N2) that follows the voltage of the output terminal.

7. The method of Claim 6, wherein the step of connecting the control terminal with a reference voltage includes the step of connecting the control terminal with a circuit for generating the reference voltage comprising a series connection of a gate-drain-connected field effect transistor (N3) and a base-collector-connected bipolar transistor (Q2).

## Patentansprüche

1. Integrierte Busschnittstellen-Treiberschaltung, mit
einem Bipolartransistor (Q1), der so angeschlossen ist, daß er in Reaktion auf ein Bustreibersignal (IN) einen Ausgangsanschluß (OUT) steuerbar auf einen vorgegebenen Pegel bringen kann; und mit
einer Rückkopplungsschaltung, die einen oder mehrere Feldeffekttransistoren umfaßt, die so angeschlossen sind, daß sie Änderungen der Spannung (Vout) des Ausgangsanschlusses (OUT) erfassen und dann, wenn eine Änderung der Ausgangsspannung (Vout) erfaßt wird, den Basisstrom des Bipolartransistors (Q1) entsprechend ändern, um dadurch den Vom Bipolartransistor (Q1) in den Ausgangsanschluß (OUT) eingegebenen Strom zu ändern, um der Änderung der Spannung (Vout) des Ausgangsanschlusses (OUT) entgegenzuwirken und den definierten Pegel aufrechtzuerhalten,
wobei der Steueranschluß eines (N2) der Feldeffekttransistoren, der so angeschlossen ist, daß er der Spannung (Vout) des Ausgangsanschlusses (OUT) folgt, an eine Referenzspannung (Vref) angeschlossen ist, die in bezug auf den definierten Ausgangspegel eingestellt wird; und
wobei die Rückkopplungsschaltung einen ersten Feldeffekttransistor (N1), der einen Basisstrom für den Bipolartransistor (Q1) bereitstellt, und einen zweiten Feldeffekttransistor (N2), welcher derjenige ist, der so angeschlossen ist, daß er der Spannung (Vout) des Ausgangsanschlusses folgt, umfaßt, wobei der zweite Feldeffekttransistor (N2) eine Gate-Spannung des ersten Feldeffekttransistors (N1) steuert und der erste Feldeffekttransistor (N1) mit einem Eingangs-Feldeffekttransistor (N0) in Reihe geschaltet ist, wobei das Bustreibersignal in den Steueranschluß des Eingangstransistors eingegeben wird.

2. Integrierte Schaltung nach Anspruch 1, bei der die Rückkopplungsschaltung ferner eine Schaltung zum Erzeugen der Referenzspannung (Vref) umfaßt,

3. Integrierte Schaltung nach Anspruch 2, bei der die Schaltung zum Erzeugen der Referenzspannung (Vref) eine Reihenschaltung aus einem Feldeffekttransistor (N3), bei dem Gate und Drain miteinander verbunden sind, und aus einem Bipolartransistor (Q2), bei dem Basis und Kollektor miteinander verbunden sind, umfaßt.

4. Integrierte Schaltung nach einem der Anspruche 1 bis 3, bei der die Ruckkopplungsschaltung temperaturkompensiert ist.

5. Integrierte Schaltung nach Anspruch 1, die ferner eine Schottky-Diode (D1) umfaßt, die zwischen einer Source des zweiten Feldeffekttransistors (N2) und dem Ausgangsanschluß (OUT) angeordnet ist.

6. Verfahren zum Steuern einer Busschnittstellenschaltung, das die folgenden Schritte umfaßt:
ein Ausgangsanschluß (OUT) wird in Reaktion auf ein Bustreibersignal (IN) mit einem Bipolartransistor (Q1) steuerbar auf einen definierten Pegel gebracht,
eine Rückkopplungsschaltung, die einen oder mehrere Feldeffekttransistoren umfaßt, wird in der Weise angeschlossen, daß der Basisstrom des Bipolartransistors (Q1) geändert wird, wenn sich die Ausgangsspannung (Vout) ändert, um dadurch den vom Bipolartransistor (Q1) in den Ausgangsanschluß (OUT) eingegebenen Strom zu ändern, um jeglicher Änderung der Spannung des Ausgangsanschlusses (OUT) entgegenzuwirken und den definierten Pegel aufrechtzuerhalten, einer (M2) der Feldeffekttransistoren wird in der Weise angeschlossen, daß er der Spannung (Vout) des Ausgangsanschlusses (OUT) folgt, und der Steueranschluß dieses Feldeffekttransistors (N2) wird an eine Referenzspannung (Vref) angeschlossen und die Referenzspannung in bezug auf den definierten Ausgangspegel gesetzt;
der Basisstrom wird durch einen weiteren Feldeffekttransistor (N1), der mit einem Eingangs-Feldeffekttransistor (N0) in Reihe geschaltet ist, bereitgestellt,
das Bustreibersignals (IN) wird in den Steueranschluß des Eingangs-Feldeffekttransistors (N0) eingegeben, wobei der weitere Feldeffekttransistor (N1) mit seinem Steueranschluß an jenen Feldeffekttransistor (N2) angeschlossen ist, der der Spannung des Ausgangsanschlusses folgt.

7. Verfahren nach Anspruch 6, bei dem der Schritt des Anschließends des Steueranschlusses an eine Referenzspannung den Schritt umfaßt, bei dem der Steueransehluß an eine Schaltung zum Erzeugen einer Referenzspannung angeschlossen wird, die eine Reihenschaltung aus einem Feldeffekttransistor (M3), dessen Gate und dessen Drain miteinander verbunden sind, und aus einem Bipolartransistor (Q2), dessen. Basis und dessen. Kollektor miteinander verbunden sind, umfaßt.

## Revendications

1. Circuit d'activation d'interface de bus intégré, comprenant
un transistor bipolaire (Q1) connecté de manière à activer d'une manière commandable une borne de sortie (OUT) à un niveau défini en réponse à un signal d'activation de bus; et comprenant
un circuit de rétroaction, qui comprend un ou plusieurs transistors à effet de champ connectés de manière à détecter des variations de la tension (Vout) de ladite borne de sortie (OUT) et par conséquent, lorsqu'une variation de ladite tension de sortie (Vout) est détectée, modifier le courant de base dudit transistor bipolaire (Q1) de manière à modifier ainsi le courant appliqué par ledit transistor bipolaire (Q1) à ladite borne de sortie (OUT) pour s'opposer à ladite variation de la tension (Vout) de ladite borne de sortie (OUT) et maintenir ledit niveau défini,
la borne de commande de l'un (N2) desdits transistors à effet de champ, qui est connectée de manière à suivre la tension (Vout) de ladite borne de sortie (OUT), est connectée à une tension de référence (Vref), ladite tension de référence étant réglée par rapport audit niveau de sortie défini; et
dans lequel ledit circuit de rétroaction comprend un premier transistor à effet de champ (N1) servant à envoyer un courant de base audit transistor bipolaire (Q1), un second transistor à effet de champ (N2) qui est celui qui est connecté de manière à suivre la tension (Vout) de ladite borne de sortie, le second transistor à effet de champ (N2) commandant une tension de grille dudit premier transistor à effet de champ (N1), et le premier transistor à effet de champ (N1) étant connecté en série à un transistor à effet de champ d'entrée (N0), le signal d'activation de bus étant appliqué à la borne de commande dudit transistor d'entrée.

2. Circuit intégré selon la revendication 1, dans lequel le circuit de réaction comprend en outre un circuit pour produire la tension de référence (Vref).

3. Circuit intégré selon la revendication 2, dans lequel le circuit servant à produire une tension de référence (Vref) comprend une connexion série d'un transistor à effet de champ (N3) à grille et drain connectés et un transistor bipolaire (Q2) à base et collecteur connectés.

4. Circuit intégré selon l'une quelconque des revendications 1 à 3, selon lequel ledit circuit de réaction est compensé en température.

5. Circuit intégré selon la revendication 4, comprenant une diode Schottky (D1) disposée entre une source dudit second transistor à effet de champ (N2) et ladite borne de sortie (OUT).

6. Procédé pour commander un circuit d'interface de bus, comprenant les étapes consistant à :
activer d'une manière commandable une borne de sortie (OUT) à un niveau défini avec un transistor bipolaire (Q1) en réponse à un signal d'activation de bus (IN),
connecter un circuit de réaction comprenant un ou plusieurs transistors à effet de champ pour modifier le courant de base dudit transistor bipolaire (Q1) lorsque ladite tension de sortie (Vout) varie, de manière à modifier ainsi le courant appliqué par ledit transistor bipolaire (Q1) sur ladite borne de sortie (OUT) pour s'opposer à toute variation de la tension dudit terminal de sortie (OUT) et maintenir ledit niveau défini, connecter l'un (N2) dudit transistor à effet de champ pour suivre la tension (Vout) de ladite borne de sortie (OUT) et connecter la borne de commande dudit transistor à effet de champ (N2) à une tension de référence (Vref) et régler ladite tension de référence par rapport audit niveau de sortie défini;
délivrer ledit courant de base au moyen d'un autre transistor à effet de champ (N1) connecté en série avec un transistor à effet de champ d'entrée (N0),
appliquer le signal d'activation de bus (IN) à la borne de commande du transistor à effet de champ d'entrée (N0), et
la borne de commande de l'autre transistor à effet de champ (N1) étant connectée au transistor à effet de champ (N2) qui suit la tension de la borne de sortie.

7. Procédé selon la revendication 6, selon lequel l'étape de connexion de la borne de commande à une tension de référence inclut l'étape consistant à connecter la borne de commande à un circuit servant à produire la tension de référence et comprenant une connexion série d'un transistor à effet de champ (N3) à grille et drain connectés et d'un transistor bipolaire (Q2) à base et collecteur connectés.
